# EUROPEAN PATENT APPLICATION

(11) **EP 4 332 679 A2**
(43) Date of publication of application: **06.03.2024**
(21) Application number: 23192097.6
(22) Date of filing: 18.08.2023
(51) Int. Cl.: G03F 9/00

(54) **INFORMATION PROCESSING APPARATUS, INFORMATION PROCESSING METHOD, STORAGE MEDIUM, EXPOSURE APPARATUS, EXPOSURE METHOD, AND ARTICLE MANUFACTURING METHOD**

(30) Priority: 29.08.2022 JP 2022136234; 07.02.2023 JP 2023017009
(71) Applicant: CANON KABUSHIKI KAISHA, Tokyo 146-8501 (JP)
(72) Inventor: OMAMEUDA, Yoshihiro, Tokyo (JP)
(74) Representative: WESER & Kollegen Patentanwälte PartmbB

(57) **Abstract**

The present invention provides an information processing apparatus (200) comprising a generator (15) configured to generate image information for causing a display unit (17) to display, as display information, any one of: difference information corresponding to a difference between first information and second information; information indicating at least one of a height and an attitude of the substrate during the exposure process of each of the plurality of shot regions; and information indicating a measurement result obtained by measuring a surface position of the substrate for each of the plurality of shot regions.

## Description

### BACKGROUND OF THE INVENTION

### Field of the Invention

The present invention relates to an information processing apparatus, an information processing method, a storage medium, an exposure apparatus, an exposure method, and an article manufacturing method.

### Description of the Related Art

As one of the apparatuses used in a manufacturing process (lithography process) for semiconductor devices, there is known an exposure apparatus that exposes each of a plurality of shot regions on a substrate by scanning the substrate with light from a projection optical system. In the exposure apparatus, in the exposure process for each shot region, while performing measurement for the surface position of a substrate (focus/tilt measurement) prior to irradiation with light, control with respect to at least one of the height and the attitude of the substrate (focus/tilt control) is performed based on the measurement result.

After the completion of the exposure process for each shot region on a substrate, the user of the exposure apparatus sometimes checks whether the exposure accuracy of each shot region satisfies a desired accuracy. If there is a shot region whose exposure accuracy does not satisfy a desired accuracy, ascertaining its cause (reason) is important to accurately perform the exposure process for a subsequent substrate. Japanese Patent Laid-Open No. 2006-165122 discloses a technique of graphing a control error (Error z) of the surface position and a control error (Error Tilt(X), Error Tilt(Y)) of the attitude of a substrate during the exposure process for each shot region.

A decrease in exposure accuracy is sometimes caused by the layout of shot regions on the substrate, as well as by control errors on the substrate during the exposure process. For example, if the layout has height differences between the plurality of shot regions on the substrate, the driving amount of the substrate sometimes increases between the plurality of shot regions, resulting in an increase in control residual error in the substrate. The method disclosed in Japanese Patent Laid-Open No. 2006-165122 does not allow the user of the exposure apparatus to ascertain that the cause for a decrease in exposure accuracy is the layout of shot regions.

### SUMMARY OF THE INVENTION

The present invention provides, for example, a technique advantageous in allowing the user of an exposure apparatus to ascertain the cause of a decrease in exposure accuracy.

The present invention in its first aspect provides an information processing apparatus as specified in claims 1 to 19.

The present invention in its second aspect provides an information processing method as specified in claim 20.

The present invention in its third aspect provides a non-transitory computer-readable storage medium as specified in claim 21.

The present invention in its fourth aspect provides an exposure apparatus as specified in claim 22.

The present invention in its fifth aspect provides an exposure method as specified in claim 23.

The present invention in its sixth aspect provides an article manufacturing method as specified in claim 24.

Further features of the present invention will become apparent from the following description of exemplary embodiments with reference to the attached drawings.

### BRIEF DESCRIPTION OF THE DRAWINGS

Fig. 1 is a schematic view showing an example of the configuration of an exposure apparatus;
Fig. 2 is a view showing an example of the operation to be performed with respect to the exposure process for each of first and second shot regions;
Fig. 3 is a view showing an example of the operation to be performed with respect to the exposure process for each of first and second shot regions;
Fig. 4 is a view showing an example of the operation to be performed with respect to the exposure process for each of first and second shot regions;
Fig. 5 is a graph showing an example of a focus/tilt difference;
Fig. 6 is a view showing an example of displaying difference information on a display unit;
Fig. 7 is a flowchart showing an operation procedure in the exposure apparatus;
Fig. 8 is a flowchart showing a processing procedure in an information processing apparatus;
Fig. 9 is a view showing an example of displaying statistic information on the display unit;
Fig. 10A is a view showing an example of displaying correction values on the display unit;
Fig. 10B is a view showing an example of displaying the prediction result of a focus/tilt difference; and
Fig. 11 is a view showing an example of the operation to be performed during the exposure process for each of first and second shot regions.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made an invention that requires all such features, and multiple such features may be combined as appropriate. Furthermore, in the attached drawings, the same reference numerals are given to the same or similar configurations, and redundant description thereof is omitted.

In the specification and the accompanying drawings, directions will be indicated on an XYZ coordinate system in which directions parallel to the surface (upper surface) of a substrate are defined as the X-Y plane. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are θX, θY, and θZ, respectively. Control or driving (movement) concerning the X-axis, the Y-axis, and the Z-axis means control or driving (movement) concerning a direction parallel to the X-axis, a direction parallel to the Y-axis, and a direction parallel to the Z-axis, respectively. In addition, control or driving concerning the θX-axis, the θY-axis, and the θZ-axis means control or driving concerning a rotation about an axis parallel to the X-axis, a rotation about an axis parallel to the Y-axis, and a rotation about an axis parallel to the Z-axis, respectively.

### <First Embodiment>

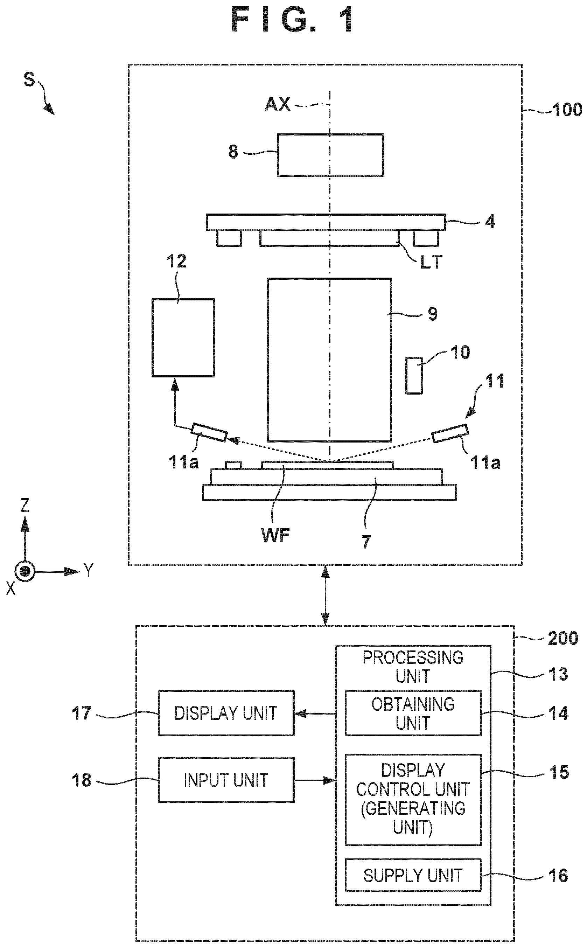

A system S according to the first embodiment of the present invention will be described. Fig. 1 is a schematic view showing an example of the configuration of the system S according to this embodiment. The system S according to the embodiment can include an exposure apparatus 100 and an information processing apparatus 200. The exposure apparatus 100 is used for a manufacturing process (lithography process) for semiconductor devices and the like and performs the exposure process for each of a plurality of shot regions on a substrate. The exposure apparatus 100 according to the embodiment is a scanning exposure apparatus that performs the exposure process for each of a plurality of shot regions on a substrate while scanning the substrate by a step and scan method. In such the exposure process, scanning exposure is performed for a shot region on a substrate by scanning the substrate with respect to exposure light (slit light or pattern light) emitted from a projection optical system, and the pattern of an original can be transferred onto a shot region on the substrate. The following will exemplify a case in which a reticle LT is used as an original, and a wafer WF is used as a substrate. Note, however, that the term "substrate" in the specification is synonymous with the wafer WF.

An example of the configuration of the exposure apparatus 100 will be described first. The exposure apparatus 100 can include an illumination optical system 8, a reticle stage 4, a projection optical system 9, a wafer stage 7, an alignment detector 10, a focus/tilt measurement device 11, and a controller 12.

The illumination optical system 8 shapes the light emitted from a light source (not shown) into slit light and illuminates the reticle LT with the slit light. The reticle LT is made of silica glass or the like, and on which a pattern (for example, a circuit pattern) to be transferred onto each shot region on the wafer WF is formed. The reticle stage 4 includes a chuck that holds the reticle LT and can move in at least one of the X- and Y-axis directions. The reticle stage 4 is scanned along the Y direction perpendicular to an optical axis AX of the projection optical system 9 during the exposure process for each shot region on the wafer WF. The exposure process can be defined as processing during a period in which a shot region on the wafer WF is exposed by being irradiated with exposure light (slit light) emitted from the projection optical system 9.

The projection optical system 9 projects, onto the wafer WF at a predetermined magnification (for example, 1/2 to 1/5), an image of the pattern on the reticle LT illuminated with light from the illumination optical system 8. The wafer WF is a substrate made of, for example, single-crystal silicon, a surface of which is coated with a resist (photosensitive agent). The wafer stage 7 includes a chuck that holds the wafer WF and can move (rotate) in the X-, Y-, and Z-axis directions and the θX, θY, and θZ directions which are rotational directions around the respective axes. The wafer stage 7 is scanned along the Y direction perpendicular to the optical axis AX of the projection optical system 9 during the exposure process for each shot region on the wafer WF.

The alignment detector 10 includes, for example, a projection system that projects detection light on a reference mark on the wafer WF and a light-receiving system that receives reflected light from the reference mark, and detects the positions (alignment positions) of the wafer WF in the X and Y directions. In this embodiment, the alignment detector 10 is configured as an off-axis alignment detection system that can optically detect the reference mark on the wafer WF without via the projection optical system 9.

The focus/tilt measurement device 11 performs measurement for the surface position of the wafer WF held by the wafer stage 7 (focus/tilt measurement). Tilts (attitude, inclination) of the wafer WF can be measured by performing focus measurement at a plurality of points. The focus/tilt measurement device 11 may be understood as a focal plane detection device. The focus/tilt measurement device 11 according to this embodiment is configured as an oblique incidence type that obliquely applies light to the wafer WF, and can include a projection unit 11a that projects a plurality of light beams for measurement onto the wafer WF and a light-receiving unit 11b that receives a plurality of light beams which are projected by the projection unit onto the wafer WF and reflected by the wafer WF. The focus/tilt measurement device 11 can measure a surface position (surface height) at each of a plurality of portions on the wafer WF which a plurality of light beams are made entered by the projection unit 11a.

The controller 12 is configured by, for example, a computer including a processor such as a Central Processing Unit (CPU) and a storage unit such as a memory and can comprehensively control the operations, adjustments, and the like of the respective constituent elements of the exposure apparatus 100. The controller 12 is connected to each constituent element of the exposure apparatus 100 via a line and can execute the exposure process for each shot region on the wafer WF by controlling each constituent element in accordance with a program and the like stored in the storage unit. For example, the controller 12 relatively scans the reticle stage 4 and the wafer stage 7 at a speed ratio corresponding to the projection magnification of the projection optical system 9 while controlling a substrate state indicating at least one of the height and the attitude (tilt) of the wafer WF with the wafer stage 7. This makes it possible to move the irradiation region irradiated with exposure light from the projection optical system 9 (that is, the region on which an image of the pattern of the reticle LT is projected by the projection optical system 9) on a shot region on the wafer WF, thereby transferring the pattern of the reticle LT onto the shot region. The exposure process for the single wafer WF can be completed by sequentially performing such the exposure process (scanning exposure) for the respective shot regions on the wafer WF. Note that a substrate state indicating at least one of the height and the attitude (tilt) of the wafer WF is sometimes referred to as a "focus/tilt" hereinafter.

An example of the configuration of the information processing apparatus 200 will be described next. The information processing apparatus 200 is communicably connected to the exposure apparatus 100 and can include a processor 13, a display unit 17 (display device), and an input unit 18 (input device). The processor 13 is configured by a computer including a processor such as a CPU (Central Processing Unit) and a storage unit such as a memory. The processor 13 according to this embodiment can include an obtaining unit 14 (obtainer) that obtains information from the exposure apparatus 100, a display control unit 15 that controls the display unit 17 based on the information obtained by the obtaining unit 14, and a supply unit 16 (supplier) that supplies (transmits, provides) information to the exposure apparatus 100. The display control unit 15 functions as a generation unit (generator) that generates image information to be displayed on the display unit 17 based on the information obtained by the obtaining unit 14, and is sometimes referred to as a "generation unit 15" hereinafter. The obtaining unit 14 and the supply unit 16 may be understood as a unit forming a communication unit that transmits and receives information to and from the exposure apparatus 100 by communication. The display unit 17 is, for example, a display and displays information under the control of the display control unit 15. The input unit 18 is, for example, a mouse or keyboard and accepts an instruction input from the user. The display unit 17 and the input unit 18 may be understood as a unit forming a user interface.

The information processing apparatus 200 according to this embodiment is configured separately (in a separate housing) from the exposure apparatus 100. However, the information processing apparatus 200 may be configured integrally with other portions of the exposure apparatus 100 (in the same housing) as a constituent element of the exposure apparatus 100. In this case, the controller 12 of the exposure apparatus 100 can have the function of as the processor 13 of the information processing apparatus 200. This embodiment exemplifies the case in which the information processing apparatus 200 includes the display unit 17 and the display control unit 15. However, the display unit 17 and the display control unit 15 may be provided outside the information processing apparatus 200 and may be provided in, for example, the exposure apparatus 100 or an external computer. In this case, the display control unit 15 located outside the information processing apparatus 200 controls display on the display unit 17 based on the image information generated by the generation unit 15 provided in the information processing apparatus 200. Although the embodiment exemplifies the case in which the information processing apparatus 200 includes the input unit 18, the input unit 18 may be provided outside the information processing apparatus 200.

### [Exposure Process for Each Shot Region]

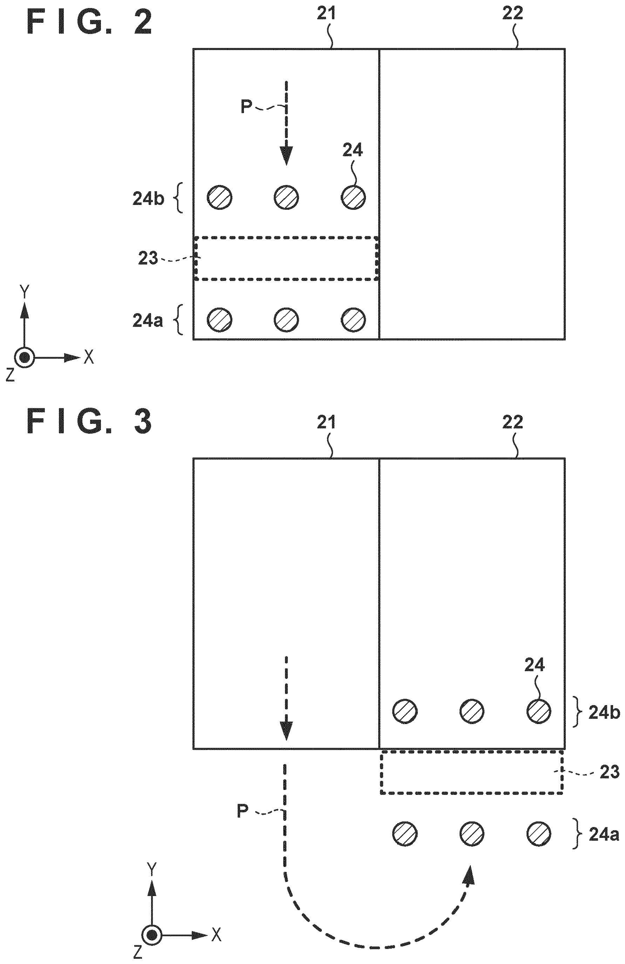

The exposure process (scanning exposure) for each of a plurality of shot regions on the wafer WF will be described next with reference to Figs. 2 to 4. The exposure process is sequentially performed for each of the plurality of shot regions on the wafer WF in a predetermined order. For the sake of easy understanding, the following description will be made focused on two shot regions (a first shot region 21 and a second shot region 22) which are consecutive in the order of the exposure process, among the plurality of shot regions on the wafer WF. The first shot region 21 and the second shot region 22 do not indicate specific shot regions on the wafer WF but simply indicate shot regions arbitrarily selected from the plurality of shot regions on the wafer WF. That is, the first shot region 21 indicates the (i - 1)th shot region (preceding shot region) one region before the second shot region. The second shot region 22 indicates the (i)th shot region (succeeding shot region) for which the exposure process is performed next to the first shot region 21. Note that "i" represents a natural number.

Figs. 2 to 4 show an example of the operation to be performed with respect the exposure process for each of the first shot region 21 and the second shot region 22. Figs. 2 to 4 show, in addition to the first shot region 21 and the second shot region 22, an irradiation region 23 irradiated with exposure light from the projection optical system 9 and a plurality of measurement points 24 at each of which the focus/tilt measurement device 11 performs focus/tilt measurement. The focus/tilt measurement is the measurement of a surface position. Referring to Figs. 2 to 4, dashed arrows P indicate the moving paths of the irradiation region 23 and the plurality of measurement points 24 with respect to the wafer WF (the first shot region 21 and the second shot region 22). The exposure apparatus 100 (the controller 12) according to this embodiment performs focus measurement at the plurality of measurement points 24 prior to the irradiation of the irradiation region 23 with exposure light in the exposure process for each shot region and concurrently performs the focus/tilt control for the wafer WF based on the measurement result.

As shown in Fig. 2, in the exposure process for the first shot region 21, the wafer WF is scanned in the +Y direction, and the focus/tilt measurement is sequentially performed prior to the irradiation of the irradiation region 23 with exposure light by using measurement points 24a among the plurality of measurement points 24. The focus/tilt of the wafer WF is sequentially controlled based on the measurement result at the measurement point 24a so as to place the wafer surface (substrate surface) inside the irradiation region 23 at the best focus position (image formation position) of the projection optical system 9. After the exposure process for the first shot region 21 is completed, as shown in Fig. 3, the wafer WF is step-moved so as to place the irradiation region 23 at the position (exposure start position) where the exposure process for the second shot region 22 is started.

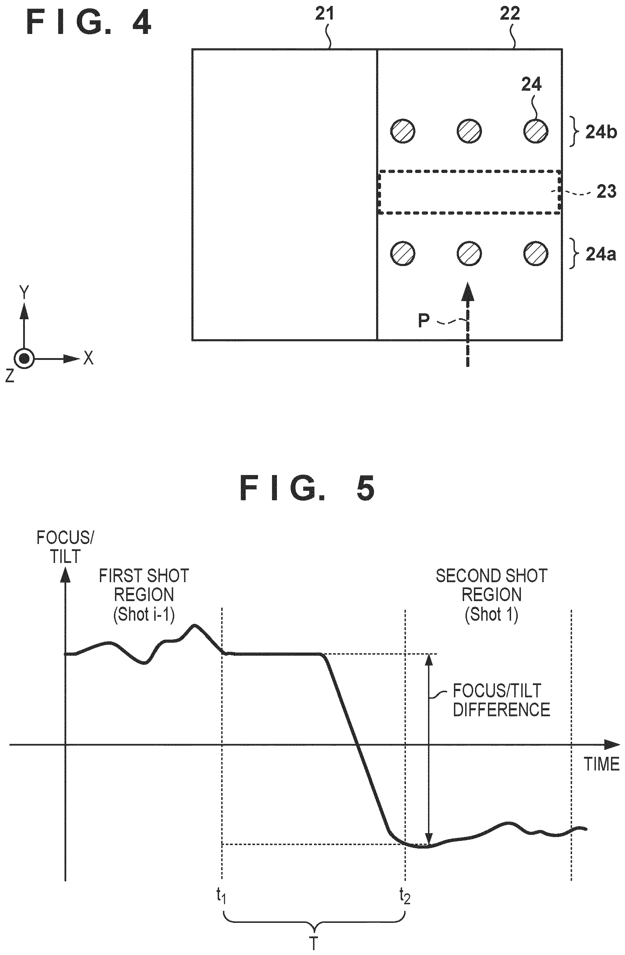

As shown in Fig. 4, in the exposure process for the second shot region 22, the wafer WF is scanned in the -Y direction, and the focus/tilt measurement is sequentially performed prior to the irradiation of the irradiation region 23 with exposure light by using measurement points 24b among the plurality of measurement points 24. The focus/tilt of the wafer WF is sequentially controlled based on the measurement result at the measurement point 24b so as to place the wafer surface inside the irradiation region 23 at the best focus position of the projection optical system 9. The focus/tilt measurement at the measurement point 24b and the focus/tilt control of the wafer WF based on the measurement result are started when the measurement point 24b enters the second shot region 22 in step-movement of the wafer WF (see Fig. 3).

### [Display of Difference Information]

After the completion of the exposure process for each shot region on the wafer WF, the user of the exposure apparatus 100 sometimes checks whether the exposure accuracy (for example, the superimposition accuracy or line width) of each shot region satisfies the desired accuracy. If there is a shot region whose exposure accuracy does not satisfy a desired accuracy, ascertaining its cause (reason) is important to accurately perform the exposure process for the subsequent wafer WF.

One cause for a decrease in exposure accuracy is the focus/tilt difference between the end time of the exposure process for the first shot region 21 (preceding shot region) and the start time of the exposure process for the second shot region 22 (succeeding shot region). Depending on such the focus/tilt difference, the driving amount of the wafer WF (substrate) increases between the end time of the exposure process for the first shot region 21 and the start time of the exposure process for the second shot region 22. Accordingly, the control residual error in the wafer WF may increase after the start of the exposure process for the second shot region 22, resulting in a decrease in exposure accuracy.

For example, Fig. 5 shows an example of the focus/tilt difference in the wafer WF between end time t1 of the exposure process for the first shot region 21 and start time t2 of the exposure process for the second shot region 22. As described above, in the exposure process for the second shot region 22, when the measurement point 24b enters the second shot region 22, focus measurement at the measurement point 24b and the focus/tilt control for the wafer WF are started. Accordingly, depending on the focus/tilt difference, it is necessary to steeply drive the wafer WF. This can increase the control residual error in the wafer WF in the exposure process for the second shot region 22.

In the information processing apparatus 200 according to this embodiment, the processor 13 (the generation unit 15) generates image information for causing the display unit 17 to display difference information (display information) which is information corresponding to a difference between first information indicating at least one of the height and the attitude of the first shot region 21 and second information indicating at least one of the height and the attitude of the second shot region 22. In this embodiment, an example in which the first information is information indicating the substrate state at the end time of the exposure process (scanning exposure) of the first shot region 21, and the second information is information indicating the substrate state at the start time of the exposure process (scanning exposure) of the second shot region 22 will be described. The difference information may be information indicating the difference between the first information and the second information itself, or may be information obtained by processing (calculating or modifying) the difference.

As described above, the substrate state is at least one of the height and the attitude of the substrate (the wafer WF), and is sometimes referred to as "focus/tilt". Therefore, the difference information according to this embodiment is information indicating a difference between the focus/tilt at the end time of the exposure process for the first shot region 21 and the focus/tilt controlled based on the measurement result of the focus/tilt measurement device 11 at the start time of the exposure process of the second shot region 22. By displaying such the difference information as the image information on the display unit 17, the user of the exposure apparatus 100 can ascertain whether the cause for a decrease in exposure accuracy is the focus/tilt difference between the end time of the exposure process for the first shot region 21 and the start time of the exposure process for the second shot region 22. Note that in the following description, the focus/tilt difference between the end time of the exposure process for the first shot region 21 and the start time of the exposure process for the second shot region 22 is sometimes simply referred as the "focus/tilt difference".

In this embodiment, the first information is information indicating the substrate state at the end time of the exposure process of the first shot region 21, and the second information is information indicating the substrate state at the start time of the exposure process of the second shot region 22. However, this is not exhaustive, and for example, the second information may be information indicating a measurement result for the second shot region 22 measured from starting the exposure process of the first shot region 21 until starting the exposure process of the second shot region 22. In this case, the difference information may be information corresponding to a difference between the first information indicating the substrate state at the end time of the exposure process of the first shot region 21 and the second information indicating the measurement result for the second shot region 22 measured from starting the exposure process of the first shot region 21 until starting the exposure process of the second shot region 22. It is also possible to combine the above descriptions. The measurement result is at least one of the height and the attitude (tilt) of the substrate obtained by measuring the surface position of the substrate, and for example, is obtained by measuring the surface position of the substrate by the focus/tilt measurement device 11. The substrate state may be determined based on the measurement result (the measurement value) itself obtained by measuring the surface position of the substrate, or may be determined based on a target value itself of the surface position of the substrate. The substrate state may be determined based on a deviation between the between the target value and the measurement value, or may be determined a command value (a drive command value in a height direction, a tilt direction or a rotation direction) generated in accordance with the deviation to drive the wafer stage 7.

Furthermore, the first information may be information indicating the measurement result of the first shot region 21, and the second information may be information indicating the measurement result of the second shot region 22. In this case, the difference information may be information corresponding to a difference between the first information indicating the measurement result of the first shot region 21 and the second information indicating the measurement result of the second shot region 22. For example, the difference information may be information corresponding to a difference between the first information indicating the measurement result at a position where the exposure process of the first shot region 21 ends, and the second information indicating the measurement result at a position where the exposure process of the second shot region 22 starts. The measurement result has the same definition as above, and may be, for example, at least one of the height and the attitude of the substrate obtained by measuring the surface positon of the substrate by the focus/tilt measurement device 11.

The exposure start time (i.e. the start time of the exposure process) according to this embodiment does not need to coincide with a timing when an exposure for the shot region starts. Similarly, the exposure start position (i.e. the position where the exposure process starts) according to this embodiment does not need to coincide with a position of a start edge of the shot region where the exposure for the shot region starts. For example, in a case where the shot region has a distortion, the exposure start position may be set to a position inside the shot region relative to the start edge, and the exposure start time may be set to a timing when the exposure start position is exposed. Alternatively, the exposure start position may be set to a position where stable driving of the wafer stage 7 starts after the start of the exposure for the shot region, and the exposure start time may be set to a timing when the exposure start position is exposed. Alternatively, in a case where a position at which the surface position of the substrate is measured deviates from a position of the start edge of the shot region due to the sampling period (i.e. the measurement period) of the focus/tilt measurement device 11, the exposure start position may be set to the position deviated from the start edge, and the exposure start time may be set to a timing when the exposure start position is exposed.

In this way, the exposure start position according to this embodiment may be set to the position of the start edge of the shot region where the exposure starts, or may be in the vicinity thereof. The exposure start time according to this embodiment may be set to the timing when the exposure of the shot region starts, or may be a timing shifted therefrom. The exposure end time (i.e. the end time of the exposure process) and the exposure end position (i.e. the position where the exposure process ends) can be set in the same manner as the exposure start time and the exposure start position. The exposure end position according to this embodiment may be set to a position of an end edge of the shot region where the exposure ends, or may be in the vicinity thereof. The exposure end time according to this embodiment may be set to the timing when the exposure of the shot region ends, or may be a timing shifted therefrom.

With respect to each of the exposure start position and the exposure end position, an allowable deviation amount will be described in detail. For example, the exposure start position may be any position within a range from a position of the start edge of the shot region to a position that is 1/3 (preferably 1/5) of the length of the shot region in the scanning direction. The exposure start time may be an timing when performing the exposure of the exposure start position determined within the range. Moreover, for example, the exposure end position may be any position within a range from a position that is 2/3 (preferably 4/5) of the length of the shot region in the scanning direction with respect to the position of the start edge of the shot region to a position of the end edge of the shot region. In the other word, the exposure end position may be any position within a range from a position of the end edge of the shot region to a position that is 1/3 (preferably 1/5) of the length of the shot region in the scanning direction. The exposure end time may be an timing when performing the exposure of the exposure end position determined within the range. Note that "exposure" can be defined as irradiating the substrate with light from the projection optical system 9, and "exposure process" can be defined as a process for irradiating the shot region with light from the projection optical system 9.

In this embodiment, the processor 13 (the obtaining unit 14) can obtain the difference information (that is, the information indicating the focus/tilt difference) obtained by the controller 12 of the exposure apparatus 100. In this case, the processor 13 (the generation unit 15) causes the display unit 17 to display the difference information obtained from the exposure apparatus 100. That is, the generation unit 15 generates the image information for causing the display unit 17 to display the difference information obtained from the exposure apparatus 100. However, the processor 13 (the obtaining unit 14) may obtain the first information indicating at least one of the height and the attitude of the first shot region 21 and the second information indicating at least one of the height and the attitude of the second shot region 22. In this case, the processor 13 (the generation unit 15) generates the difference information based on the first information and the second information obtained from the exposure apparatus 100 and causes the display unit 17 to display the generated difference information. That is, the generation unit 15 generates the difference information based on the first information and the second information obtained from the exposure apparatus 100 and generates the image information for causing the display unit 17 to display the generated difference information.

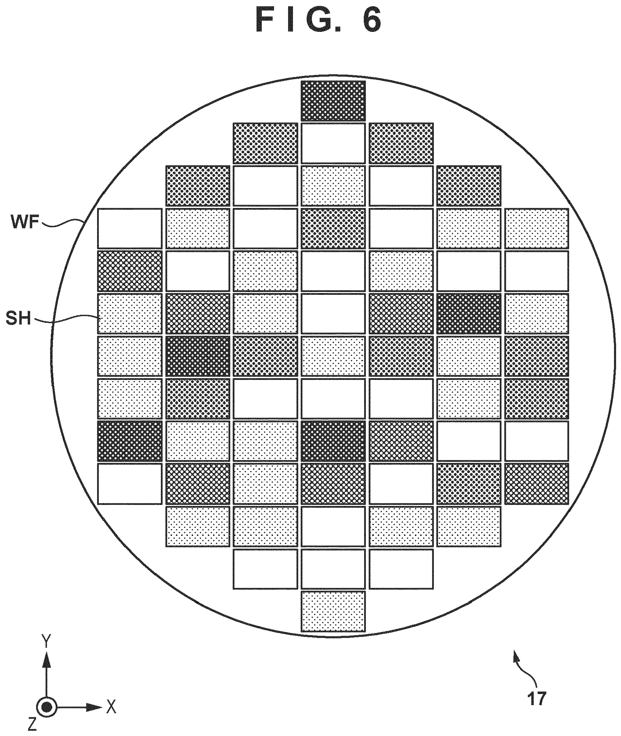

Fig. 6 shows a display example of the difference information on the display unit 17. The example in Fig. 6 displays, as the difference information, a distribution representing the magnitudes of the focus/tilt differences at the respective positions of shot regions SH on the wafer WF in color density in accordance with the layout of the plurality of shot regions SH on the wafer WF. The display of the difference information may include display in the form of a table or the like as well as display matching the layout of the plurality of shot regions SH on the wafer WF. In addition, the display of the difference information may include display with color types, numerical values, and the like and display with different color densities and types on which numerical values are superimposed as well as display with different color densities. That is, any type of display can be used as long as the user can visually recognize the difference information. The generation unit 15 generates the image information of difference information to be displayed by the display unit 17 so as to enable the user to visually recognize the difference information by using at least one of the above display examples.

In addition, in a case where the exposure process is executed over a plurality of wafers WF (substrates), the generation unit 15 may display, on the display unit 17, the representative values of the focus/tilt differences in the plurality of wafers WF as the difference information at the respective positions of shot regions. That is, the generation unit 15 may generate the image information for causing the display unit 17 to display the representative values of the focus/tilt differences in the plurality of wafers WF as the difference information at the respective positions of the shot regions. Representative values include, for example, average values, median values, maximum values, and mode values.

In a case where the focus/tilt difference in the difference information is large, the driving amount of the wafer WF between the end time of the exposure process for the first shot region 21 and the start time of the exposure process for the second shot region 22 (that is, during step-movement of the wafer WF) increases. When the driving amount is large, it causes increases in the control residual error in the wafer WF and error in the focus/tilt measurement device 11 after the start of the exposure process for the second shot region 22as described above. In addition, in a case where the shot region is located at an edge portion of the wafer WF, it can cause problems such as failure to detect the tilt component of the wafer WF and a decrease in focus/tilt measurement accuracy because of a limited number of measurement points. Since such problems are displayed as the difference information on the display unit 17, the user of the exposure apparatus 100 can easily and properly ascertain the cause of the decrease in exposure accuracy by checking the difference information via the display unit 17.

In this embodiment, as the difference information, information corresponding to a difference in the substrate state or the measurement result between the exposure end time of the first shot region 21 and the exposure start time of the second shot region 22 has been exemplified. However, this is not exhaustive, and for example, the difference information may be information corresponding to a difference in the substrate state or the measurement result between a central portion of the first shot region 21 in the scanning direction and a central portion of the second region 22 in the scanning direction. That is, the difference information may be information corresponding to a difference between the substrate state during the exposure process of the first shot region 21 and the substrate state during the exposure process of the second shot region 22. In addition, the difference information is not based on a position in a shot region, but may be information corresponding to a difference between the measurement result obtained by measuring an inside of the first shot region 21 and the measurement result obtained by measuring an inside of the second shot region 22. Alternatively, the difference information may be information corresponding to a difference between a focus/tilt value obtained by averaging the substrate state or the measurement result at a plurality of positions in the first shot region 21 and a focus/tilt value obtained by averaging the substrate state or the measurement result at a plurality of positions in the second shot region 22. Note that the central portion can be defined as a range having a predetermined width in the scanning direction and an opposite direction thereto with respect to a barycenter (center) of the shot region, the predetermined width can be set to 1/3 (preferably 1/5) of the length of the shot region in the scanning direction.

In this embodiment, an example of displaying the difference information in the scanning exposure as the exposure process to the display unit 17 has been described, but the difference information in the step exposure as the exposure process may be displayed to the display unit 17. In this case, as described above, the difference information may be information corresponding to a difference between the first information indicating the substrate state during the exposure process (the step exposure) of the first shot region 21 and the second information indicating the substrate state during the exposure process (the step exposure) of the second shot region 22. Alternatively, the difference information is not based on a position in a shot region, but may be information corresponding to a difference between the first information indicating the measurement result obtained by measuring an inside of the first shot region 21 and the second information indicating the measurement result obtained by measuring an inside of the second shot region 22. In a case where the substrate state or the measurement result is obtained multiple times in each shot region, the difference information may be information corresponding to a difference in the substrate state or the measurement results obtained at a central portion in each shot region between the first shot region 21 and the second shot region 22. the difference information may be information corresponding to a difference of the combination that becomes the largest when the difference is obtained. Alternatively, the difference information may be information corresponding to a difference between the first information indicating a focus/tilt value obtained by averaging the substrate state or the measurement result at a plurality of positions in the first shot region 21 and the second information indicating a focus/tilt value obtained by averaging the substrate state or the measurement result at a plurality of positions in the second shot region 22.

Displaying the difference information in accordance with the layout of a plurality of shot regions on the wafer WF allows the user to visually ascertain a place influenced by structural characteristics due to undulation occurring in the wafer WF, bonding of the wafer WF, and the like. That is, the user can properly recognize the influences of the focus/tilt differences on the manufacturing process of the wafer WF. This can lead to an improvement in the manufacturing process.

In addition, the causes for a decrease in exposure accuracy can include, for example, the undulation of the wafer WF, lens-related focal position errors, the influences of air conditioning, and vibrations transmitted to the exposure apparatus in addition to the focus/tilt difference. However, as in this embodiment, by focusing on the focus/tilt differences and displaying the difference information indicating focus/tilt differences, the user can easily and properly ascertain the causes in the decrease in exposure accuracy from the viewpoint of the focus/tilt differences. That is, ascertaining the causes from the viewpoint of the focus/tilt differences helps improving the manufacturing process of the wafer WF.

### [Generation of Correction Values]

The exposure apparatus 100 according to this embodiment may obtain (determine) correction values for correcting focus/tilt so as to reduce the focus/tilt differences. The correction values are calculated for the respective positions of shot regions and can be applied to the respective shot regions on the subsequent wafer WF (second substrate).

For example, in a case where the focus/tilt difference is obtained by using the first wafer WF (first substrate), the controller 12 calculates (generates) a correction value for driving the wafer (the wafer stage 7) so as to reduce the focus/tilt difference during step-movement. The correction value in this embodiment corrects at least one of the height (focus) and the attitude (posture, tilt) as the substrate states at the start time of the exposure process for the second shot region 22. In this embodiment, the wafer (the wafer stage 7) is driven upon setting, as a target value (target focus value, target tilt value), the substrate state at the start of the exposure process for the second shot region 22 when a correction value is applied. Note that the correction value may be configured to correct at least one of the height (focus) and the attitude (posture, tilt) of the substrate on the wafer stage 7 (substrate holding unit) at the start time of the exposure process for the second shot region 22. That is, the correction value is a value to be used to correct the substrate state or the target value (for example, a target position, target coordinates, target focus value, or target tilt value) of the wafer stage 7.

The correction values are calculated for the respective positions of shot regions and stored in the storage unit. The controller 12 can apply the correction value to each shot region on the second wafer WF (second substrate) for which the exposure process is performed after the first wafer WF. More specifically, after the end of the exposure process for the preceding shot region (the first shot region 21) and before the start of focus/tilt measurement on the succeeding region (the second shot region 22) in the second wafer WF, the focus/tilt of the second wafer WF is controlled based on the correction value. That is, the correction value obtained based on the focus/tilt (its driving history) in the exposure process for the first wafer WF is a value used for correcting the substrate state or the target value of the wafer stage 7 with respect to the exposure process for the second wafer WF.

By applying the correction value in this manner, it is possible to start the focus/tilt control before the start of the focus/tilt measurement. This makes it possible to reduce steep driving of a wafer as compared with a case in which focus/tilt control is started after the start of focus/tilt measurement without application of the correction value. That is, applying the correction value can reduce the control residual error in a wafer in the exposure process.

The controller 12 may obtain the correction values for the respective positions of shot regions by using the first wafer WF, and apply, to the second wafer WF, the correction value obtained for a shot region selected by the user among the plurality of shot regions on the first wafer WF. For example, the display control unit 15 of the information processing apparatus 200 causes the display unit 17 to display the difference information for the respective positions of shot regions on in accordance with the layout of shot regions on the wafer WF so as to allow the user to select whether to apply the correction value for the respective positions of shot regions. That is, the generation unit 15 generates the image information for causing the display unit 17 to display the difference information for the respective positions of shot regions in accordance with the layout of shot regions on the wafer WF so as to allow the user to select whether to apply the correction value for the respective positions of shot regions. In this case, the user can select the position of a shot region to which the correction value should be applied via the input unit 18 by referring to the difference information displayed on the display unit 17 for the respective positions of shot regions. The position information of the shot region selected by the user is supplied to the exposure apparatus 100 (the controller 12) by the supply unit 16. This enables the controller 12 of the exposure apparatus 100 to apply the correction value to a given shot region, among the plurality of shot regions on the subsequent second wafer WF, which is located at the same position as that of the shot region selected by the user.

The controller 12 may determine the correction value to be applied to the second wafer WF without selection by the user. More specifically, the controller 12 may apply, to the second wafer WF, the correction value obtained for a shot region, among the plurality of shot regions on the first wafer WF, which has the focus/tilt difference equal to or more than a threshold. This makes it possible to apply the correction value to only a shot region where a large decrease in exposure accuracy is predicted. In other words, this can reduce applying correction values to shot regions exhibiting high possibility of decreases in exposure accuracy due to the application of the correction values.

Note that the controller 12 may select the correction value by using machine learning. However, machine learning does not provide a result of 100%. Accordingly, in order to improve the accuracy, it is desirable for the user to select the correction value. In this embodiment, as described above, the difference information is displayed on the display unit 17 as information for determination (evaluation index) that enables the user to select the correction value. In addition, although machine learning requires sufficient learning data, it is difficult to prepare sufficient learning data because preprocessing and exposure conditions for wafers sequentially change. In this embodiment, since the difference information is displayed on the display unit 17, the user can select a shot region to which the correction value is to be applied, thus eliminating the need to use machine learning requiring sufficient learning data.

### [Operation Procedure in Exposure Apparatus]

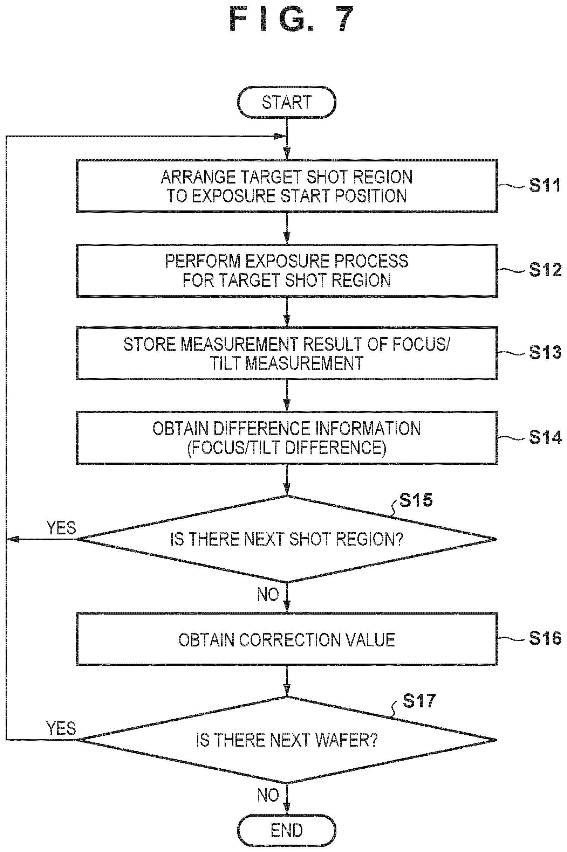

An operation procedure in the exposure apparatus 100 according to this embodiment will be described with reference to Fig. 7. Fig. 7 is a flowchart showing an operation procedure in the exposure apparatus 100 according to this embodiment. Each step in the flowchart in Fig. 7 can be executed by the controller 12. Before the start of the flowchart in Fig. 7, the wafer WF is transferred onto the wafer stage 7 by using a wafer transfer mechanism (not shown).

In step S11, the controller 12 performs step-movement of the wafer WF by the wafer stage 7 so as to arrange a target shot region to the exposure start position. The target shot region is a shot region, among the plurality of shot regions on the wafer WF, for which the exposure process is to be performed. The order of the exposure process for each of the plurality of shot regions on the wafer WF is set in advance. In step S12, the controller 12 performs the exposure process for the target shot region. In the exposure process, as described above, the controller 12 causes the focus/tilt measurement device 11 to perform the focus/tilt measurement prior to irradiation of the irradiation region 23 with exposure light and concurrently controls the focus/tilt of the wafer WF based on the measurement result. In step S13, the controller 12 stores the measurement result of the focus/tilt measurement obtained in step S12 in the storage unit.

In step S14, the controller 12 obtains, as the difference information, a focus/tilt difference which is a difference between the focus/tilt at the start time of the exposure process in step S12 and the focus/tilt at the end time of the exposure process for the preceding shot region. The focus/tilt difference has already been described above, and hence a detailed description thereof will be omitted. In a case where the exposure process has been performed for a plurality of wafers WF, a representative value (for example, an average value) of the focus/tilt difference in the plurality of wafers WF may be obtained as the difference information. In addition, no focus/tilt difference can be obtained with respect to a shot region, among the plurality of shot regions on the wafer WF, for which the exposure process is to be performed for the first time, and hence step S14 may be omitted.

In step S 15, the controller 12 determines whether there is any shot region for which the exposure process has not yet been performed (to be sometimes referred to as a next shot region hereinafter). If there is a next shot region, the process advances to step S11 after the next shot region is set as the target region. In contrast to this, if there is no next shot region, that is, the exposure process has been performed for all the shot regions on the wafer WF, the process advances to step S16.

In step S16, the controller 12 obtains, based on the focus/tilt difference obtained in step S14, the correction value for correcting the focus/tilt so as to reduce the focus/tilt difference. The correction values are obtained for the respective positions of shot regions. As described above, the correction value for a shot region, among a plurality of shot regions, which is selected by the user in accordance with the display of the difference information can be applied to the succeeding wafer. Alternatively, the correction value for a shot region, among the plurality of shot regions, in which the focus/tilt difference is equal to or more than a threshold can be applied to the succeeding wafer. The correction values may be sequentially changed every time the exposure process for a wafer is repeated, for the respective positions of shot regions.

In step S17, the controller 12 determines whether there is any wafer WF for which the exposure process has not yet been performed (to be sometimes referred to as the next wafer WF hereinafter). If there is the next wafer WF, the process advances to step S 11 after the wafer WF on the wafer stage 7 is changed (replaced) by using the wafer transfer mechanism (not shown). In contrast to this, if there is no next wafer WF, the flowchart is ended after the wafer WF is unloaded from the wafer stage 7 by using the wafer transfer mechanism (not shown).

### [Processing Procedure in Information Processing Apparatus]

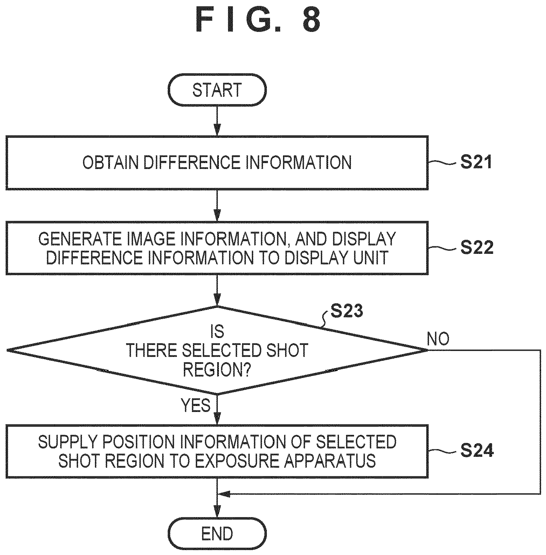

A processing procedure in the information processing apparatus 200 according to this embodiment will be described with reference to Fig. 8. Fig. 8 is a flowchart showing a processing procedure in the information processing apparatus 200 according to this embodiment. Each step in the flowchart in Fig. 8 can be executed by the processor 13. For example, the flowchart in Fig. 8 can be executed every time the exposure process for one wafer is completed in the flowchart in Fig. 7.

In step S21, the processor 13 (the obtaining unit 14) obtains the difference information determined in the exposure apparatus 100, from the exposure apparatus 100, for the respective positions of shot regions. In step S22, the processor 13 (the display control unit 15) displays, on the display unit 17, the difference information obtained in step S21 for the respective positions of shot regions position. That is, the generation unit 15 generates image information for displaying, on the display unit 17, the difference information obtained in step S21 for the respective positions of shot regions. For example, the processor 13 may display, on the display unit 17, the difference information for the respective positions of shot regions in accordance with the layout of the shot regions on the wafer WF or may generate the image information for displaying such the difference information. This enables the user to properly ascertain whether the cause of a decrease in exposure accuracy is the focus/tilt difference.

In step S23, the processor 13 determines whether there is any shot region selected by the user via the input unit 18. If there is the shot region selected by the user, the process advances to step S24. In step S24, the processor 13 (the supply unit 16) supplies (transmits) the position information of the shot region selected by the user to the exposure apparatus 100. This enables the exposure apparatus 100 to apply the correction value to only a shot region, among the plurality of shot region in the subsequent wafer (substrate), which is located at the same position as the shot region selected by the user. That is, the correction value can be applied to each shot region on the subsequent wafer in accordance with a request from the user.

As described above, the information processing apparatus 200 according to this embodiment generates the image information for causing the display unit 17 to display the difference information (display information) which is information corresponding to a difference between the first information indicating at least one of the height and the attitude of the first shot region 21 (preceding shot region) and the second information indicating at least one of the height and the attitude of the second shot region 22 (succeeding shot region). This enables the user of the exposure apparatus 100 to properly ascertain, based on information displayed on the display unit 17, whether the cause of a decrease in exposure accuracy is a focus/tilt difference.

This embodiment has exemplified the measurement result and the substrate state obtained by measuring the surface position of the substrate. However, these pieces of information correspond to the state (substrate holding unit state) of the wafer stage 7 (substrate holding unit). The state of the wafer stage 7 is the state or position of the focus/tilt when the wafer stage 7 is driven. That is, the display information may be the difference information generated as information indicating a difference between the substrate holding unit state at the end time of the exposure process for the first shot region 21 and the substrate holding unit state at the start time of the exposure process for the second shot region. The substrate holding unit state indicates the state of the wafer stage 7 (substrate holding unit). Alternatively, the display information may be the difference information generated as information indicating a difference between the substrate holding unit state at the end time of the exposure process for the first shot region 21 and the measurement result on the second shot region 22 which is measured from the start of the exposure process for the first shot region 21 until the start of the exposure process for the second shot region 22.

### <Second Embodiment>

The second embodiment according to the present invention will be described. This embodiment will describe an example in which the exposure process is executed over a plurality of wafers WF, and statistic information (dispersion information, second information) indicating the dispersion of the focus/tilt differences in the plurality of wafers WF is displayed on a display unit 17 at the respective positions of shot regions. In this example, in a case where the exposure process is executed over a plurality of wafers WF, the generation unit 15 generates the image information for causing the display unit 17 to display the statistic information indicating the dispersion of the focus/tilt differences in the plurality of wafers WF at the respective positions of shot regions. Note that this embodiment basically inherits the first embodiment, and matters other than those described below can comply with the first embodiment.

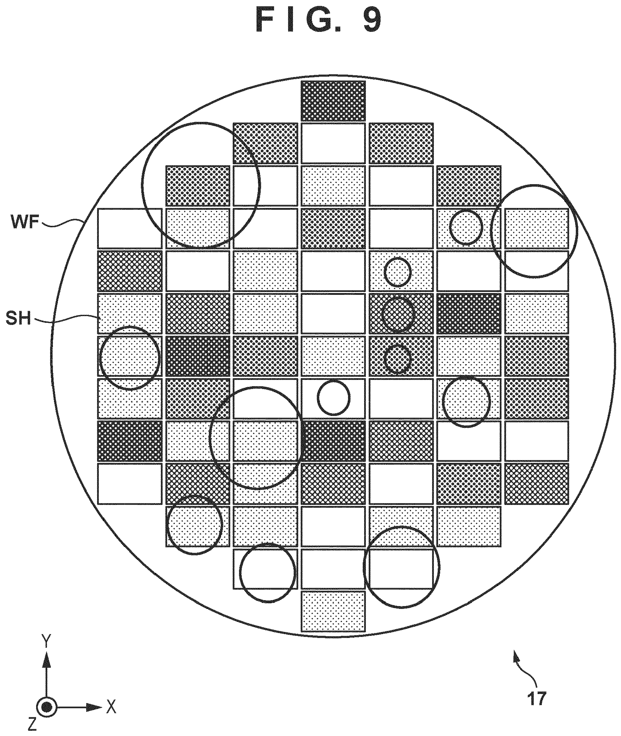

Fig. 9 shows a display example of the statistic information on the display unit 17. In the example in Fig. 9, the statistic information is represented by the size of a circle and superimposed on the difference information (the display information) on the display unit 17. The dispersion of the focus/tilt differences in the statistic information includes standard deviation and skewness. Displaying the statistic information in this manner enables the user to further properly ascertain whether the cause of a decrease in exposure accuracy is the focus/tilt difference and to further properly select a shot region to which the correction value is to be applied. For example, the user can determine, based on the display of the statistic information, whether the correction value is preferably not applied at the position of a shot region exhibiting a relatively large dispersion. In addition, displaying a plurality of pieces of information including the difference information and the statistic information enables the user to further properly recognize the influence of the focus/tilt difference on the manufacturing process of the wafer WF based on the plurality of pieces of information. This can lead to an improvement in the manufacturing process.

In the example in Fig. 9, the difference information is represented by a color density, and the statistic information is represented by the size of a circle. However, this is not exhaustive, and the difference information and the statistic information may be represented by other display forms. For example, the difference information may be represented by a color type, and the statistic information may be represented by a bubble map. In addition, the difference information and the statistic information may be separately displayed on the display unit 17.

### <Third Embodiment>

The third embodiment according to the present invention will be described. This embodiment will describe an example in which the correction values calculated for the respective positions of shot regions are displayed on a display unit 17. In this example, the generation unit 15 generates the image information for causing the display unit 17 to display the correction values calculated for the respective positions of shot regions. Note that this embodiment basically inherits the first embodiment, and matters other than those described below can comply with the first embodiment. The second embodiment may be applied to the third embodiment.

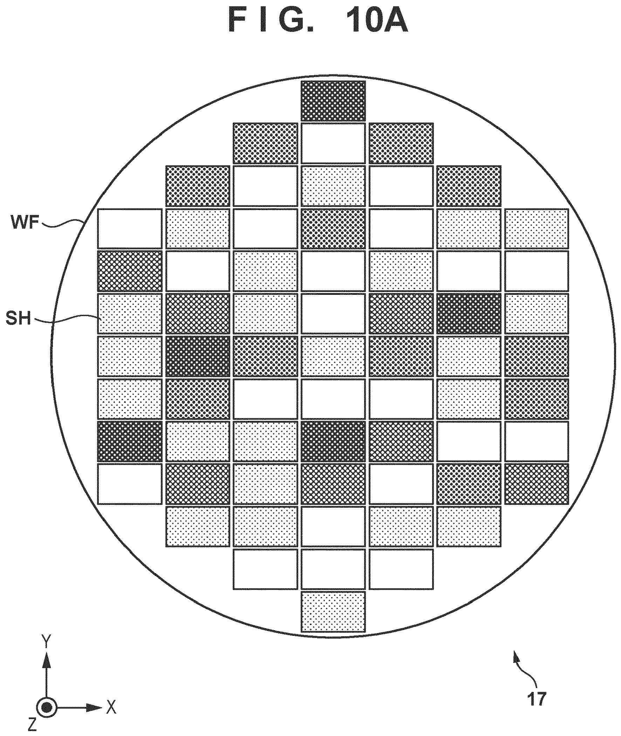

Fig. 10A shows a display example of the correction values on the display unit 17. In the example in Fig. 10A, the magnitudes of the correction values (that is, the driving amount of the wafer for focus/tilt correction) are represented for the respective positions of shot regions by a color density, in accordance with the layout of a plurality of shot regions SH on the wafer WF. The display of correction values is not limited to display matching the layout of a plurality of shot regions SH on the wafer WF and may be display using a table and the like. The display of correction values is not limited to display using color densities and may be display using color types, numerical values, and the like or display having numerical values superimposed on color densities and types.

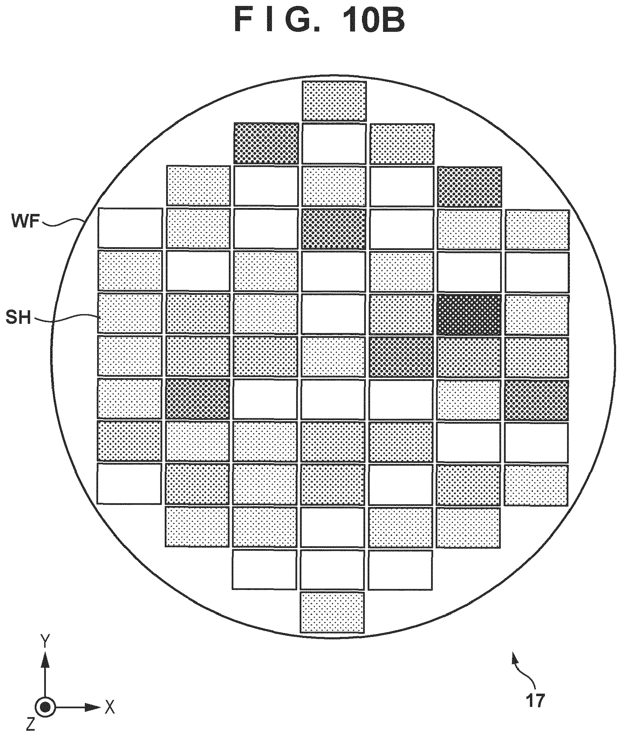

The display control unit (generation unit) 15 may predict, for the respective positions of shot regions, the focus/tilt differences remaining when the correction values are applied to the subsequent wafer WF (second substrate) and display the prediction result on the display unit 17. That is, the generation unit 15 may predict, for the respective positions of shot regions, the focus/tilt differences remaining when the correction values are applied to the subsequent wafer WF (second substrate) and generate the image information for displaying the prediction result on the display unit 17. Fig. 10B shows a display example of the prediction result on the focus/tilt differences remaining when the correction values are applied to the respective shot regions SH on the subsequent wafer WF. This enables the user to ascertain, based on the display of the prediction result, how much the focus/tilt differences are reduced and how much the focus/tilt differences remain, when correction values are applied to the subsequent wafer WF. That is, the user can further properly select a shot region to which the correction value should be applied, via the input unit 18 based on the display of the prediction result.

In this case, a controller 12 may display, on the display unit 17, the prediction result of the focus/tilt difference when the correction value is not applied, in addition to the prediction result (Fig. 10B) of the focus/tilt difference when the correction value is applied. In this case, the user can compare a prediction result with the application of the correction value with a prediction result without the application of the correction value and hence can recognize the effect obtained by applying the correction value. That is, the user can intuitively understand the effectiveness of the correction value and also use the effectiveness to determine whether to apply the correction value to the subsequent wafer.

### <Fourth Embodiment>

The fourth embodiment according to the present invention will be described. Note that this embodiment basically inherits the first embodiment, and matters other than those described below can comply with the first embodiment. The second and third embodiments may be applied to the fourth embodiment.

In the above first embodiment, the difference information for the respective positions of shot regions is represented as one index. However, the difference information (display information) may be divided into a plurality of direction components and displayed on a display unit 17. For example, a display control unit (generation unit) 15 may divide the focus/tilt difference in the difference information into a Z-direction focus component, a θX-direction tilt component, and a θY-direction tilt component and separately display the respective components on the display unit 17. That is, the generation unit 15 may divide the focus/tilt difference in the difference information into a Z-direction focus component, a θX-direction tilt component, and a θY-direction tilt component and generate the image information for causing the display unit 17 to separately display the respective components. For example, the magnitude of a focus component can be represented by a color density or type. The magnitude of a tilt component can also be represented by a color density or type. The direction of a tilt component may be represented by providing gradation for the changing direction of tilting. Each direction component may be displayed in an entire shot region but may be displayed in only a portion measured by the focus/tilt measurement device 11. This enables the user to determine which direction component has a large influence in the focus/tilt difference.

### <Fifth Embodiment>

The fifth embodiment according to the present invention will be described. Note that this embodiment basically inherits the first embodiment, and matters other than those described below can comply with the first embodiment. The second to fourth embodiments may be applied to the fifth embodiment.

The focus/tilt difference (difference information, display information) in the above embodiment may be the amount of focus/tilt of a wafer WF driven from the end time of the exposure process for the preceding shot region to the start time of the exposure process for the next shot region. Alternatively, the focus/tilt difference in the above embodiment may be the result of measuring the difference between the end edge of the preceding shot region and the start edge of the succeeding shot region by using an external measurement apparatus without using the focus/tilt measurement device 11.

### <Sixth Embodiment>

The sixth embodiment according to the present invention will be described. Note that this embodiment basically inherits the first embodiment, and matters other than those described below can comply with the first embodiment. The second to fifth embodiments may be applied to the sixth embodiment.

In this embodiment, a controller 12 may apply (reflect) the correction value to only the shot region selected by the user based on the information (difference information, statistic information, display information) displayed on a display unit 17. For example, based on the information displayed on the display unit 17, the user can exclude shot regions exhibiting large dispersions and select only a shot region for which the correction value can be effectively used as a shot region to which the correction value is applied.

For example, because of the structure of a wafer, large dispersions tend to occur in shot regions including bonding portions and portions in which coating unevenness of the resist tends to occur, and the application of a correction value to such shot regions sometimes reduces the exposure accuracy against intention. Displaying the difference information or the statistic information on the display unit 17 enables the user to properly select a shot region to which the correction value is to be applied, while checking the information. Even if the user does not comprehend such structural characteristics of a wafer, the user can select shot regions based on dispersions as indices. Displaying the difference information (a representative value) and the statistic information (a dispersion) on the display unit 17 enables the user to determine, based on the magnitude of the information, whether the correction value can be effectively used. For example, even if the dispersion in a given shot region is large to some extent, it is expected to obtain a good result by the application of a correction value as long as the average value is sufficiently large. It is also possible to determine whether to select and apply a latest correction value, of the correction values for the respective shot regions obtained from one wafer, which tend to be influenced by filtering based on the time axis.

In addition, selecting a plurality of wafers instead of the same wafer makes it possible to check the degree of influence of the wafer stage 7 (the substrate holding unit including the substrate chuck) holding the wafers from a higher perspective. For example, it is possible to determine that the influence of wafers on a portion exhibiting a large average value is higher than that of the chuck. This makes it possible to examine, for example, whether to change the layout of shot regions, as well as to effectively apply the correction value.

In addition, at a wafer portion with a relatively small height difference, such as a portion near the center of a wafer, a sufficient exposure accuracy can be sometimes ensured without using any correction value. In a shot region arranged in such a portion, an improvement in exposure accuracy can be expected without applying any correction value. That is, the user can determine, based on display on the display unit 17, whether to apply a correction value while checking, for example, a range near the center of a wafer.

### <Seventh Embodiment>

The seventh embodiment according to the present invention will be described. Note that this embodiment basically inherits the first embodiment, and matters other than those described below can comply with the first embodiment. The second to sixth embodiments may be applied to the seventh embodiment.

In this embodiment, the difference information (display information) and the measurement result (inspection result) of exposure accuracy are simultaneously displayed. More specifically, the measurement result (inspection result) obtained by a measurement apparatus (inspection apparatus) or the like and the difference information are superimposed and displayed or displayed on the display unit 17 at positions allowing comparison. This enables the user to easily compare the exposure accuracy with the difference information. A generation unit 15 generates the image information for causing the display unit 17 to simultaneously display the difference information and the measurement result (inspection result) of the exposure accuracy. The display control unit 15 controls the display unit 17 to simultaneously display the difference information and the measurement result (inspection result) of the exposure accuracy.

### <Eighth Embodiment>

The eighth embodiment according to the present invention will be described. Note that this embodiment basically inherits the first embodiment, and matters other than those described below can comply with the first embodiment. The second to seventh embodiments may be applied to the eighth embodiment. For example, the operation of generating the image information for displaying the difference information as described in the above embodiment may be rewritten as generating the image information for displaying information described in this embodiment.

A generation unit 15 according to this embodiment generates the image information for displaying, on a display unit 17, one of the difference information described in the above embodiment, information indicating at least one of the height and the attitude of the substrate (i.e. substrate state) during the exposure process for each of the plurality of shot regions, and information indicating the measurement result obtained by measuring the surface position of the substrate for each of the plurality of shot region. The measurement result may be defined as indicating at least one of the height and the attitude of the substrate.

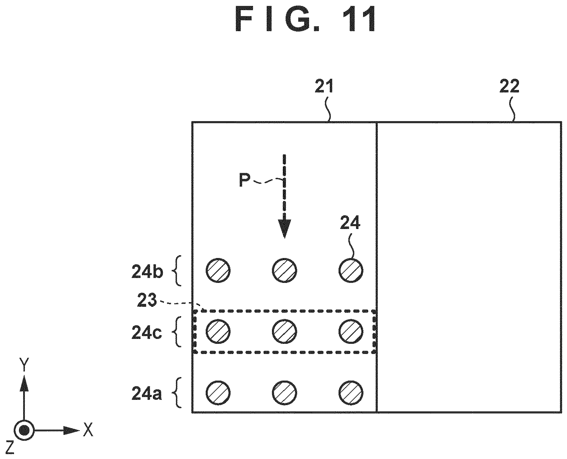

For example, the substrate state during the exposure process for each of the plurality of shot regions may be a substrate state at the exposure start time for each of the plurality of shot regions, or may be a substrate state for each of the plurality of shot regions when a specific position within each shot region is exposed. In addition, for example, the measurement result for each of the plurality of shot regions may be a measurement result obtained by measuring the exposure start position for each of the plurality of shot regions, or may be a measurement result obtained for each of the plurality of shot regions by measuring a specific position within each shot region. Furthermore, as shown in Fig. 11, the measurement result may be a result of the focus/tilt measurement performed by the measurement points 24a or 24b prior to the irradiation of the irradiation region 23 with exposure light, or may be a result of the focus/tilt measurement performed by a measurement points 24c arranged in the irradiation region 23. Fig. 11 corresponds to Fig. 2, and shows an example in which the measurement point 24c of the focus/tilt measurement device 11 is arranged inside the irradiation region 23.

According to this embodiment, it is possible to display, on the display unit 17, the image information which is information selected from the difference information, information indicating at least one of the height and the attitude of the substrate (i.e. substrate state) during the exposure process for each of the plurality of shot regions, and information indicating the measurement result obtained by measuring the surface position of the substrate for each of the plurality of shot region. This also allows the user of the exposure apparatus 100 to ascertain the cause of the decrease in exposure accuracy.

### <Ninth Embodiment>

The ninth embodiment according to the present invention will be described. Note that this embodiment basically inherits the first embodiment, and matters other than those described below can comply with the first embodiment. The second to eighth embodiments may be applied to the ninth embodiment.

A generation unit 15 according to this embodiment is characterized by generating the image information for displaying, on a display unit 17, the display information based on the inspection result obtained from an external inspection apparatus. The external inspection apparatus is, for example, a height detection apparatus that can detect the height of each of a plurality of shot regions on a substrate. An exposure apparatus 100 or an information processing apparatus 200 generates the display information based on the information detected by the detection apparatus. The generation unit 15 then generates the image information for displaying the generated display information on the display unit 17.

The display information in this embodiment may be information corresponding to a difference between the measurement result for the first shot region 21 and the measurement result for a second shot region 22. Alternatively, the display information may be the measurement result itself for each of a plurality of shot regions. The measurement result indicates at least one of the height and the attitude of the substrate.

### <Embodiment of Article Manufacturing Method>

An article manufacturing method according to the embodiment of the present invention is suitable for manufacturing an article, for example, a microdevice such as a semiconductor device or a device having a microstructure. The article manufacturing method according to this embodiment includes a step (a step of exposing a substrate) of forming a latent image pattern on a photosensitive agent on a substrate by using the above-described exposure apparatus (exposure method), a step of processing (developing) the substrate on which the latent image pattern is formed, and a step of manufacturing an article from the processed substrate. The manufacturing method further includes other known steps (oxidation, film formation, deposition, doping, planarization, etching, resist removal, dicing, bonding, packaging, and the like). The article manufacturing method of this embodiment is more advantageous than the conventional methods in at least one of the performance, quality, productivity, and production cost of the article.

### <Other Embodiments>

Embodiment(s) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An information processing apparatus (200) comprising a generator (15) configured to generate image information for causing a display unit (17) to display, as display information, any one of:
difference information corresponding to a difference between first information and second information, the first information indicating at least one of a height and an attitude of a first shot region among a plurality of shot regions on a substrate for each of which an exposure process is performed by an exposure apparatus (100), and the second information indicating at least one of a height and an attitude of a second shot region for which the exposure process is performed next to the first shot region among the plurality of shot regions;
information indicating at least one of a height and an attitude of the substrate during the exposure process of each of the plurality of shot regions; and
information indicating a measurement result obtained by measuring a surface position of the substrate for each of the plurality of shot regions.

2. The information processing apparatus according to claim 1, wherein
the first information is information indicating at least one of a height and an attitude of the substrate at an end time of the exposure process for the first shot region, and
the second information is information indicating at least one of a height and an attitude of the substrate at a start time of the exposure process for the second shot region.

3. The information processing apparatus according to claim 1, wherein
the first information is information indicating at least one of a height and an attitude of the substrate at an end time of the exposure process for the first shot region, and
the second information is information indicating at least one of a height and an attitude of the substrate obtained by measuring a surface position of the substrate for the second shot region until a start time of the exposure process for the second shot region.

4. The information processing apparatus according to claim 1, wherein
the first information is information indicating at least one of a height and an attitude of the substrate obtained by measuring a surface position of the substrate for the first shot region, and
the second information is information indicating at least one of a height and an attitude of the substrate obtained by measuring a surface position of the substrate for the second shot region.

5. The information processing apparatus according to claim 1, wherein the generator is configured to generate the image information for causing the display unit to display a distribution representing the display information for respective positions of shot regions on the substrate.

6. The information processing apparatus according to claim 1, wherein the generator is configured to generate the image information indicating the display information by at least one of a color density, a color type, and a numerical value so as to enable a user to visually recognize the display information for respective positions of shot regions on the substrate.

7. The information processing apparatus according to claim 1, wherein in a case where the exposure process has been executed for each of a plurality of substrates, the generator is configured to generate the image information for causing the display unit to display, for respective positions of shot regions, a representative value of the display information on the plurality of substrates.

8. The information processing apparatus according to claim 1, wherein in a case where the exposure process has been executed for each of a plurality of substrates, the generator is configured to generate the image information for causing the display unit to display, for respective positions of shot regions, statistic information indicating dispersion of the display information on the plurality of substrates.

9. The information processing apparatus according to any one of claims 1 to 8, further comprising an obtainer (14) configured to obtain information from the exposure apparatus,
wherein the generator is configured to generate the image information for causing the display unit to display the display information, based on the information obtained from the exposure apparatus by the obtainer.

10. The information processing apparatus according to any one of claims 1 to 8, further comprising an obtainer configured to obtain information from the exposure apparatus,
wherein the obtainer is configured to obtain the display information from the exposure apparatus, and
wherein the generator is configured to generate the image information for causing the display unit to display the display information obtained by the obtainer.

11. The information processing apparatus according to any one of claims 1 to 8, wherein the generator is configured to generate the image information for causing the display unit to display the display information upon dividing the display information into a plurality of direction components.

12. The information processing apparatus according to any one of claims 1 to 8, wherein the generator is configured to generate the image information for causing the display unit to display the display information for respective positions of shot regions, so as to enable a user to select whether to apply a correction value for reducing the difference for the respective positions of shot regions.

13. The information processing apparatus according to claim 12, further comprising:
an input unit (18) configured to accept an instruction input from the user; and
a supplier (16) configured to supply, to the exposure apparatus, position information of a shot region selected by the user via the input unit.

14. The information processing apparatus according to any one of claims 1 to 8, wherein the generator is configured to predict a residual difference at a start time of the exposure process for each shot region on a subsequent substrate in a case where a correction value for reducing the difference is applied to the subsequent substrate, and generate the image information for causing the display unit to display a prediction result of the residual difference so as to enable a user to select whether to apply the correction value for respective positions of shot regions.

15. The information processing apparatus according to any one of claims 1 to 8, wherein the exposure apparatus is a scanning exposure apparatus configured to perform the exposure process while scanning the substrate, and is configured to measure a surface position of the second shot region in the exposure process for the second shot region and concurrently control at least one of a position and a tilt of the second shot region based on a measurement result of the surface position.

16. The information processing apparatus according to any one of claims 1 to 8, wherein the information processing apparatus is communicably connected to the exposure apparatus.

17. The information processing apparatus according to any one of claims 1 to 8, wherein the information processing apparatus is integrally formed as a constituent element of the exposure apparatus with the exposure apparatus.

18. The information processing apparatus according to any one of claims 1 to 8, wherein the generator is configured to generate the image information for causing the display unit to simultaneously display the display information and an inspection result on exposure accuracy of the exposure process.

19. The information processing apparatus according to any one of claims 1 to 8, wherein the display information is information based on an inspection result obtained by an inspection apparatus located outside the information processing apparatus.

20. An information processing method of processing information of an exposure apparatus (100) that performs an exposure process for each of a plurality of shot regions on a substrate, the method comprising:
obtaining information from the exposure apparatus; and
generating, based on the obtained information from the exposure apparatus, image information for causing a display unit (17) to display, as display information, any one of:
difference information corresponding to a difference between first information and second information, the first information indicating at least one of a height and an attitude of a first shot region among a plurality of shot regions on a substrate for each of which an exposure process is performed by an exposure apparatus, and the second information indicating at least one of a height and an attitude of a second shot region for which the exposure process is performed next to the first shot region among the plurality of shot regions;
information indicating at least one of a height and an attitude of the substrate during the exposure process of each of the plurality of shot regions; and
information indicating a measurement result obtained by measuring a surface position of the substrate for each of the plurality of shot regions.

21. A non-transitory computer-readable storage medium storing a program for causing a computer to execute an information processing method according to claims 20.

22. An exposure apparatus (100) that performs an exposure process for each of a plurality of shot regions on a substrate, the exposure apparatus comprising:
a measurement device (11) configured to measure, after completion of the exposure process for a first shot region among the plurality of shot regions, a surface position of a second shot region for which the exposure process is performed next to the first shot region among the plurality of shot regions; and
a controller (12) configured to control at least one of a height and an attitude of the substrate based on a measurement result obtained by the measurement device, in the exposure process for the second shot region,
wherein the controller is configured to generate image information for causing a display unit (17) to display, as display information, any one of:
difference information corresponding to a difference between first information and second information, the first information indicating at least one of a height and an attitude of the first shot region, and the second information indicating at least one of a height and an attitude of the second shot region;
information indicating at least one of a height and an attitude of the substrate during the exposure process of each of the plurality of shot regions; and
information indicating a measurement result obtained by measuring a surface position of the substrate for each of the plurality of shot regions.

23. An exposure method of performing exposure process for each of a plurality of shot regions on a substrate, the method comprising:
measuring, after completion of the exposure process for a first shot region among the plurality of shot regions, a surface position of a second shot region for which the exposure process is performed next to the first shot region among the plurality of shot regions;
controlling at least one of a height and an attitude of the substrate based on a measurement result for the surface position of the second shot region, in the exposure process for the second shot region; and
generating image information for causing a display unit (17) to display, as display information, any one of:
difference information corresponding to a difference between first information and second information, the first information indicating at least one of a height and an attitude of the first shot region, and the second information indicating at least one of a height and an attitude of the second shot region;
information indicating at least one of a height and an attitude of the substrate during the exposure process of each of the plurality of shot regions; and
information indicating a measurement result obtained by measuring a surface position of the substrate for each of the plurality of shot regions.

24. An article manufacturing method comprising:
performing an exposure process for each of a plurality of shot regions on a substrate;
processing the substrate exposed in the exposing; and
manufacturing an article from the substrate processed in the processing,
wherein the exposing includes:
measuring, after completion of the exposure process for a first shot region among the plurality of shot regions, a surface position of a second shot region for which the exposure process is performed next to the first shot region among the plurality of shot regions,
controlling at least one of a height and an attitude of the substrate based on a measurement result for the surface position of the second shot region, in the exposure process for the second shot region, and
generating image information for causing a display unit (17) to display, as display information, any one of:
difference information corresponding to a difference between first information and second information, the first information indicating at least one of a height and an attitude of the first shot region, and the second information indicating at least one of a height and an attitude of the second shot region;
information indicating at least one of a height and an attitude of the substrate during the exposure process of each of the plurality of shot regions; and
information indicating a measurement result obtained by measuring a surface position of the substrate for each of the plurality of shot regions.
